# EUROPEAN PATENT APPLICATION

(11) **EP 4 390 408 A1**
(43) Date of publication of application: **26.06.2024**
(21) Application number: 22307001.2
(22) Date of filing: 22.12.2022
(51) Int. Cl.: G01R 19/25, G01R 31/08

(54) **SYSTEM FOR MONITORING LEAKAGE CURRENTS IN HIGH-VOLTAGE CABLES**

(71) Applicant: Nexans, 92400 Courbevoie (FR)
(72) Inventor: DOEDENS, Espen, 1788 HALDEN (NO); FRISK, Nils-Bertil, 45297 STRÖMSTAD (SE); EYSSAUTIER, Quentin, 1734 HAFSLUNDSOY (NO)
(74) Representative: Ipsilon

(57) **Abstract**

A system for monitoring leakage currents in high-voltage cables comprises one or more sensors (301), which monitor the physical properties of the cable and acquire detection data, a processor (304) configured to use the detection data to simulate the thermal and electrical fluxes in the cables, and a digital twin monitoring unit (306). The digital twin monitoring unit calls the detection data, performs digital twin modelling of the high-voltage cable based on the detection data, and the simulated thermal and electrical fluxes, generates a digital twin, and uses the digital twin to perform online monitoring of the high-voltage cable to be measured, and provide a report (307) of the monitoring.

## Description

### TECHNICAL FIELD

The present invention concerns a system for monitoring leakage currents in high-voltage cables by means of a physical-based digital twin.

### BACKGROUND

Leakage currents in HVDC cable systems, and HVAC systems (of 1kV and above), are indicative of the electrical losses in the insulation system and are thus a good marker to check the health and margins of a cable system in operation. The applicant has measured such currents in the lab for many years, but there is a need for improvements. Safe measurement of such currents on an actual cable link in operation requires special sensors. High voltage direct current (HVDC) lines are more difficult to monitor when compared to alternating current lines as the conventional current transformers cannot be used to measure DC current. Presently, there is no commercially available, clamp-on type, non-intrusive devices for HVDC line insulator leakage current measurements.

Also, over the last years, partial discharge (PD) measurements have become a valuable tool for quality control. But even in well screened laboratories the measured results can be affected by external interference. Therefore, the interpretation of PD data can be a challenge. A common method is the interpretation of phase-resolved PD patterns, where all pulses are allocated to a certain phase position of the test voltage. Since DC measurements must be done without phase information, the interpretation becomes even more difficult.

Previously, non-physics based digital twins, have used artificial intelligence or algorithms to compare measured signals against a database.

A digital twin is a digital representation of an intended or actual real-world physical product, system, or process that serves as the effectively indistinguishable digital counterpart of it for practical purposes, such as simulation, integration, testing, monitoring, and maintenance. The digital twin has been intended from its initial introduction to be the underlying premise for Product Lifecycle Management and exists throughout the entire lifecycle, create, build, operate/support, and dispose, of the physical entity it represents. The digital twin can and does often exist before there is a physical entity.

Once informed with such data, the virtual model can be used to run simulations, study performance issues and generate possible improvements, all with the goal of generating valuable insights - which can then be applied back to the original physical object.

While such a solution can interpret the measured signals and provide a health indicator for the cable system operator, they do not include the thermo-electric physics of the cable system. Therefore, physics-based digital twins, which include a live simulation of thermal and electrical fluxes in the cable system, can provide better insights and improve the interpretation of the measured data.

The object of the invention is to develop a physics-based digital twin solution for this measurement along with leakage current measurement signals.

Physics based will in this context mean a model that takes into account the electro-thermal fluxes and phenomena of the cable system but is not reserved to only such properties. The physics-based digital twin solution takes into account the physical characteristics of the system/device and gives thus a more specific model of the system/device to be monitored.

The object of the invention is achieved by means of the features of the patent claims.

### SUMMARY OF THE INVENTION

A physics based digital twin encompasses (but is not limited to) one or more of the following elements:
- Electrical and thermal parameters of the cable layer materials as well as the cable geometry.
- The voltage and currents applied to the cable system.
- The conductivity, permittivity and associated internal electric field distribution in the cable system.
- The electrical losses in the cable system, such as conductor and insulation Joule losses, but not limited to these.
- The heat generation from such losses.
- The internal heat conduction in the cable system.
- The heat evacuation to the local cable environment.
- The thermal impact on conductivity in the cable forming a computational closed loop.

In one embodiment, a system for monitoring leakage currents in high-voltage cables comprises one or more sensors, which monitor the physical properties of the cable and acquire detection data, a processor configured to use the detection data to simulate the thermal and electrical fluxes in the cables, and a digital twin monitoring unit.

The digital twin monitoring unit calls the detection data, performs data twin modelling of the high-voltage cable based on the detection data and the simulated thermal and electrical fluxes, generates a one-, two-, or three-dimensional digital twin, and uses the digital twin to perform online monitoring of the high-voltage cable to be measured, and obtains a report of the monitoring.

The sensors can be any sensors that measure properties of the high-voltage cable that are relevant for the cable or cable system of which the cable is a part. Particularly, the sensors are sensors that are configured to measure leakage currents from grounding points in the cable link, such as opto-magnetic Hall effect clamp on the ground connections of the cables, optical sensors and/or resistive shunts, thermal sensors configured to measure temperature increase along the cable or other temperature incidents, etc. Also distributed temperature sensors (DTS), voltage sensors, etc. can be used.

Further input may also be used into the system to facilitate the simulations of electric properties and provide a representative model closely representing the cable or cable system. The processor can be configured to receive input from cable design computations, and/or input from measurements of the cable performed during manufacturing of the cable. This kind of information will provide further insight in the physical properties of the cable and/or cable system, thus increasing the accuracy of the simulations and/or models.

The digital twin monitoring unit can be configured to perform location estimation of abnormalities and faults of the high-voltage cable to be tested based on historical data of the high-voltage cable to be tested.

The digital twin modelling can also take into account the voltage and currents applied to the cable.

The system may also comprise means for issuing an alarm when the monitoring report comprises an abnormality or failure.

In a further aspect a method for monitoring leakage currents in high-voltage cables is provided. The method comprising:
- monitoring the physical properties of cables and acquiring detection data;
- simulating the thermal and electrical fluxes in the cables using the detection data,
- generating a digital twin by calling the detection data, performing digital twin modelling of the high-voltage cable based on the detection data, and the simulated thermal and electrical fluxes, and
- using the digital twin to perform online monitoring of the high-voltage cable to be measured, and provide a report of the monitoring.

The method may further comprise using input from cable design computations in generating the digital twin.

Additionally, the method may comprise using input from measurements of the cable performed during manufacturing of the cable in generating the digital twin.

The method can also comprise performing location estimation of abnormalities and faults of the high-voltage cable to be tested based on historical data of the high-voltage cable to be tested.

Further the method may include issuing an alarm when the monitoring report comprises an abnormality or failure.

### BRIEF DESCRIPTION OF THE DRAWINGS

In the following, embodiments of the present invention will be described in detail with reference to the enclosed drawings, where
Fig. 1 illustrates a cable and the building elements of a high voltage cable.
Fig. 2 illustrates schematically a system for monitoring leakage currents in high-voltage cables.
Fig. 3 is a flow chart illustrating the process of providing a digital twin.

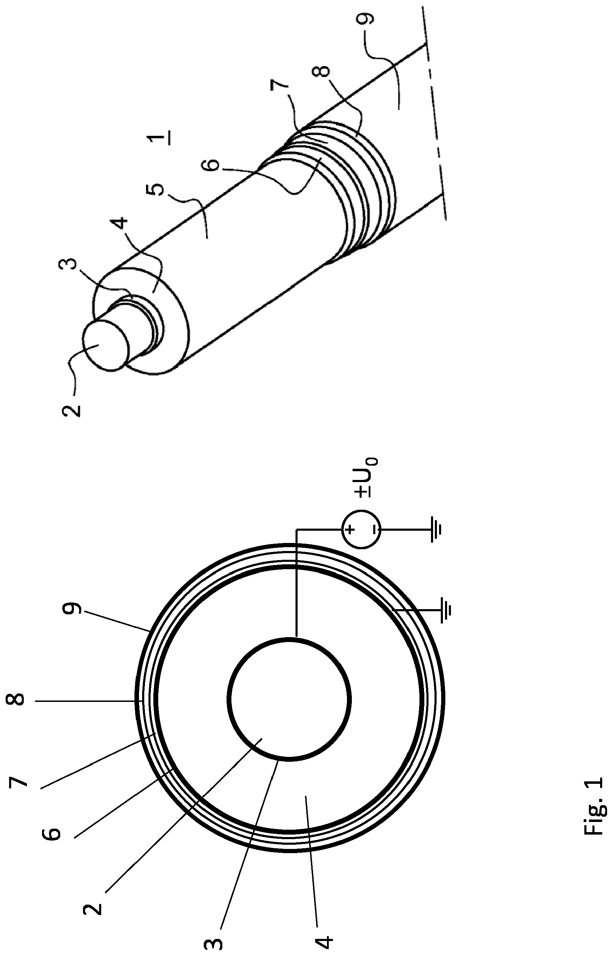

Figure 1 illustrates a detailed view of an example of a high voltage cable. As shown is an exemplary high voltage cable end 1, where the outer sheath 9, the lead sheath 8, swelling tapes 7 and the outer semiconducting screen 6 have been removed, leaving the conductor 2, the inner semiconducting screen 3 and the insulation 4. The surface 5 of the insulation 4 can in this example be inspected to ensure that there are no irregularities, but as explained above, there is a need for a system and method for monitoring leakage currents of cables without relying on manual inspection.

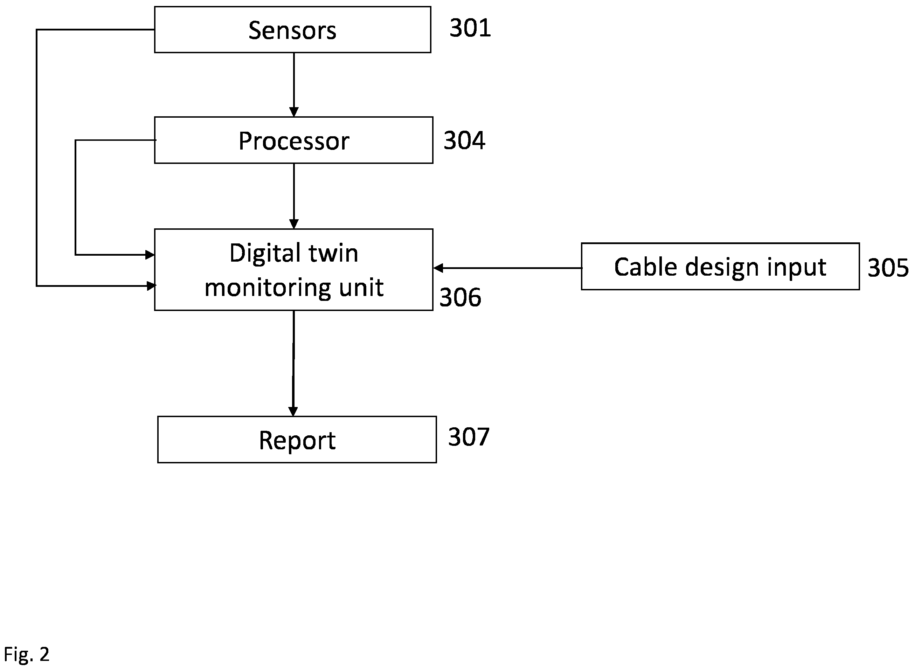

Figure 2 illustrates schematically a system for monitoring leakage currents in high-voltage cables. The system comprises one or more sensors 301, which monitor the physical properties of the cable and acquire detection data. A processor 304 is configured to use the detection data to simulate the thermal and electrical fluxes in the cables. A digital twin monitoring unit 306 receives the detection data and performs digital twin modelling of the high-voltage cable based on the detection data and the simulated thermal and electrical fluxes, generates a digital twin, and uses the digital twin to perform online monitoring of the high-voltage cable to be measured. The digital twin monitoring unit 306 then can provide a report 307 of the monitoring.

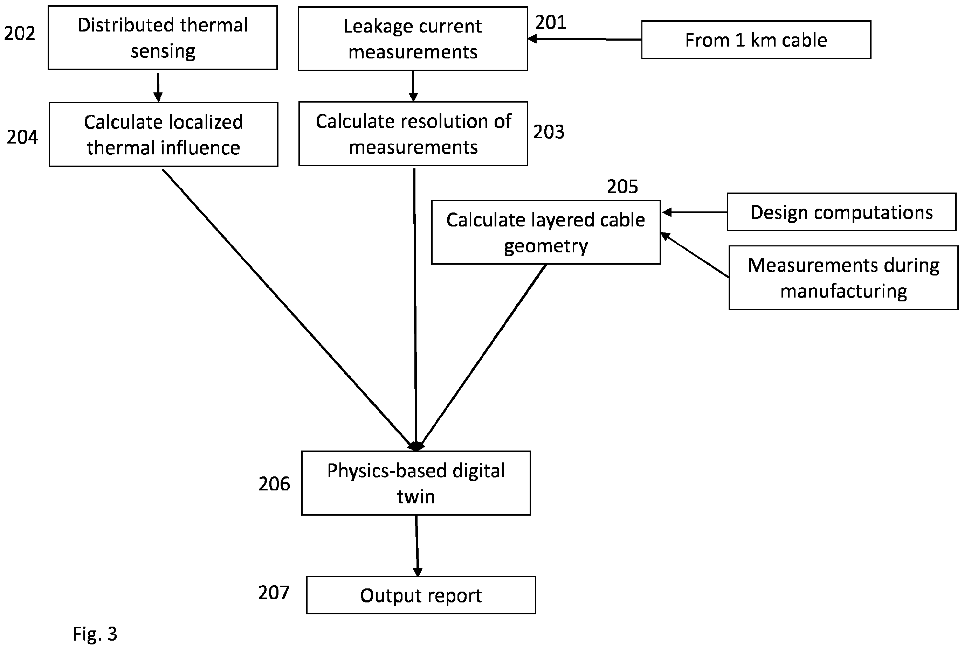

In figure 3, the monitoring of leakage currents by means of designing a physical digital twin is illustrated as a flow chart.

To operate such a physics-based digital twin, measurement inputs from leakage current measurement 201 can be performed. Such measurements can be obtained from grounding points in the cable link by means of optical sensors and/or resistive shunts and/or other suitable measurement methods. The measured leakage current can then come from approximately 1 km cable sections, and the measured signals with be the total leakage current for such segments.

In addition to such measurement inputs coming from an extended length of cable, distributed thermal sensing (DTS) systems 202 can be implemented, for example by means of an optical fiber implemented on the cable. This provides a continuous temperature profile along the length of the cable and such a system can give more precisely localized temperature data, indicative of leakage currents. While these two inputs can be considered to be basic ones, the system should not be limited to these, as other measurements can be employed, potentially improving the accuracy in the resulting physics-based algorithm.

The different lengthwise resolutions of measurement inputs are calculated 203, 204, in a physics-based algorithm, providing data on localized thermal influence along with potentially lengthwise altering thermal cable system environments.

The cable geometry 205 can also be calculated. This includes the radial layers of the cable, ie. the cable's construction is used in the algorithm. Such calculations can be based on inputs from cable design computations before manufacturing the cable, or measurements obtained during manufacturing of the cable or a combination of these.

The information regarding the cable design can then be input (305 in figure 2) to the digital twin monitoring unit 306 in figure 2 where it can be used in the digital twin modelling of the high-voltage cable.

The physics-based digital twin is produced in step 206 in figure 3, based on the information above. The physics-based digital twin will comprise a representation of the electrical and thermal parameters of the cable layer materials as well as the cable geometry. The digital twin may further comprise the voltage and currents applied to the cable or a cable system comprising one or more cables. Other characteristics that should be included in the digital twin are the conductivity, permittivity and associated internal electric field distributions in the cable system.

The digital twin will be able to provide the electrical losses in the cable system, such as conductor and insulation Joule losses, but not limited to these, as well as heat generation from such losses, internal heat conduction in the cable system, heat transferred to the local cable environment surrounding the cable and the thermal impact on conductivity in the cable forming a computational closed loop.

The physics-based digital twin thus comprises an algorithm that provides a complete representation of the physics of the cable, in particular the electro-thermal properties.

The outputs 207 of the physics-based digital twin can comprise estimates of localized dielectric losses, providing a tool with substantially increased reliability with respect to non-physics based digital twins to anticipate electro-thermal runaway or other critical operation scenarios for the cable during operation.

Furthermore, by calculating the cable physics, non-preventable scenarios such as short-term overloads or other non-standard operation conditions can be better assessed, and thus early intervention can be done to prevent or reduce consequences of such conditions.

As the physics-based digital twin comprises a representation of the layers in the cable, it allows to track the electric field and temperature dependent conductivity in the insulation layer and to detect any evolution in its individual parameters, such as the alpha, beta, and base level conductivity parameters in the Klein's conductivity expression. Monitoring and tracking such evolution along with the local thermal history of the cable link can provide anticipation of electrical performance and can possibly detect ageing markers. Such information can enable the operator to make the correct decisions, which may lead to an extension of the cable system lifetime.

The data can be exploited for the in-service line where it is used but data can also be recorded in a database in order to improve or better understand such systems.

Such an algorithm utilizes a high number of physical parameters unique to each specific cable, such as the layers used in the cable design, manufacturing conditions, and the cable's history. It may therefore be desirable to ensure that the data are not used for other purposes, misused or sent to other non-authorized parties. This can be ensured by encrypting certain aspects of the algorithm and/or the data used in the algorithm.

In some embodiments, the physics based digital twin is installed on the computer used to other operations of the cable, but it may in other embodiments be run as a cloud service.

Furthermore, such a physics based digital twin have the potential to be further improved after its implementation, for example due to new or updated information with respect to the design of the cable, for example materials, dimensions, etc. of the layers of the cable, better resolution of measurements, updated models of the electro-thermal properties etc. To update the digital twin, one or both of the following features may be implemented:
- Automatically transfer and updates to new iterations through over-the-air (OTA) updates
- Certain algorithms can be operating as edge-computing software where processed measurement raw data, link operational parameters as well as algorithm performance indicators are automatically transferred to a data cloud where the digital twin processes such data further into usable parameters for the system link operator, and stores indicators of past performance. The processed information is then fed back to the cable link operator providing live feedback on the electrical aspects of the cable link.

Other methods and processes that improve and/or update the digital twin may also be implemented as appropriate. For example, in some cases the operator will want a system that fully operates behind their firewall. In such a case updates can be done more seldomly, and such updates can be implemented on the hardware running the twin manually.

## Claims

1. A system for monitoring leakage currents in high-voltage cables comprising
- one or more sensors (301), which monitor the physical properties of the cable and acquire detection data;
- a processor (304) configured to use the detection data to simulate the thermal and electrical fluxes in the cables,
- a digital twin monitoring unit (306), where the digital twin monitoring unit calls the detection data, performs digital twin modelling of the high-voltage cable based on the detection data, and the simulated thermal and electrical fluxes, generates a digital twin, and uses the digital twin to perform online monitoring of the high-voltage cable to be measured, and provide a report (307) of the monitoring.

2. System according to claim 1, where the processor (304) is configured to receive input (305) from cable design computations.

3. System according to claim 1 or 2, where the processor (304) is configured to receive input from measurements of the cable performed during manufacturing of the cable.

4. System according to claim 1, where the digital twin monitoring unit (306) is further configured to perform location estimation of abnormalities and faults of the high-voltage cable to be tested based on historical data of the high-voltage cable to be tested.

5. System according to claim 1, where the sensors (301) are optical sensors and/or resistive shunts.

6. System according to claim 5, where the sensors (301) are configured to measure (201) leakage currents from grounding points in the cable link.

7. System according to claim 5 or 6, where the sensors (301) are configured to measure (202) temperature increase along the cable.

8. System according to one of the preceding claims, where the digital twin modelling takes into account the voltage and currents applied to the cable.

9. System according to one of the preceding claims, further comprising means for issuing an alarm when the monitoring report (307) comprises an abnormality or failure.

10. Method for monitoring leakage currents in high-voltage cables comprising:
- monitoring the physical properties of cables and acquiring detection data;
- simulating the thermal and electrical fluxes in the cables using the detection data,
- generating (206) a digital twin by calling the detection data, performing digital twin modelling of the high-voltage cable based on the detection data, and the simulated thermal and electrical fluxes, and
- using the digital twin to perform online monitoring of the high-voltage cable to be measured, and provide a report (307) of the monitoring.

11. Method according to claim 10, comprising using input (305) from cable design computations in generating the digital twin.

12. Method according to claim 10 or 11, comprising using input from measurements of the cable performed during manufacturing of the cable in generating the digital twin.

13. Method according to claim 10, comprising performing location estimation of abnormalities and faults of the high-voltage cable to be tested based on historical data of the high-voltage cable to be tested.

14. Method according to claim 10, comprising issuing an alarm when the monitoring report comprises an abnormality or failure.
